# EUROPÄISCHE PATENTSCHRIFT

(11) **EP 1 886 359 B1**
(45) Veröffentlichungstag und Bekanntmachung des Hinweises auf die Patenterteilung: **03.07.2019**
(21) Anmeldenummer: 06722836.1
(22) Anmeldetag: 05.05.2006
(51) Int. Cl.: H01L 23/498, H01L 31/0203, H01L 33/48, H01L 33/62, H01L 23/00

(54) **HOUSING BODY AND METHOD FOR ITS MANUFACTURE**
GEHÄUSEKÖRPER UND VERFAHREN ZU DESSEN HERSTELLUNG
CORPS DE BOITIER ET PROCEDE POUR LE REALISER

(30) Priorität: 30.05.2005 DE 102005024668
(43) Veröffentlichungstag der Anmeldung: 13.02.2008
(73) Patentinhaber: OSRAM Opto Semiconductors GmbH, 93055 Regensburg (DE)
(72) Erfinder: BOGNER, Georg, 93138 Lappersdorf (DE); ARNDT, Karlheinz, 93077 Bad Abbach (DE)
(74) Vertreter: Epping - Hermann - Fischer
(86) Internationale Anmeldenummer: PCT/DE2006/000778
(87) Internationale Veröffentlichungsnummer: WO 2006/128416

(56) Entgegenhaltungen:
- EP-A1- 0 400 175
- EP-A2- 0 646 971
- GB-A- 2 395 605
- JP-A- H05 275 750
- US-A- 5 223 746
- US-A1- 2004 208 210
- US-A1- 2004 251 044
- US-A1- 2005 093 146
- US-A1- 2005 156 189
- US-A1- 2005 213 334

## Beschreibung

Die Erfindung betrifft einen Gehäusekörper und ein Verfahren zu dessen Herstellung.

Ein derartiger Gehäusekörper kann für ein Bauelement verwendet werden, das aufgrund seiner lateralen Abstrahlung als seitlich emittierendes Bauelement (sogenannter Sidelooker) bezeichnet wird. Das seitlich emittierende Bauelement kann auf unterschiedliche Weise hergestellt sein. Beispielsweise kann es auf der Basis eines Leiterrahmens ("Leadframe") hergestellt sein.

Aus der Offenlegungsschrift EP 0 400 175 A1 ist ein Sidelooker bekannt, der einen metallischen Träger als Leadframe mit elektrischen Anschlüssen aufweist, wobei ein Halbleiterchip auf einen der Anschlüsse aufgebracht ist. Der Halbleiterchip und Teile der Anschlüsse werden nach dem Aufbringen des Halbleiterchips mit Kunststoff, z.B. mit Duroplasten oder mit Thermoplasten, umspritzt, wobei der Kunststoff das Gehäuse des Sidelookers bildet. Der Sidelooker kann infrarotes oder sichtbares Licht senden und/oder empfangen.

Bei einem seitlich emittierenden Bauelement, das ein Gehäuse mit einem derartigen Kunststoffmaterial enthält, besteht bei Strahlung einer Wellenlänge unter etwa 500 nm die Gefahr einer Degradation beziehungsweise einer Materialermüdung des Gehäuses. Dies kann die Betriebsdauer des Bauelements erheblich senken.

Die Druckschrift US 2005/0093146 A1 betrifft ein seitlich emittierendes Gehäuse für LED-Chips, das viertelkreisförmige Lötbereiche an Ecken aufweist.

In der Druckschrift GB 2 395 605 A findet sich ein Gehäuse für LED-Chips, das aus mehreren Keramiklagen zusammengesetzt ist.

Aus der Druckschrift US 2004/0208210 A1 ist ein Multichip-LED-Gehäuse bekannt, das mehrlagig aufgebaut ist.

Ein Gehäusekörper mit den Merkmalen des Oberbegriffs des Anspruchs 1 ist der Druckschrift JP H05-275 750 A zu entnehmen.

Es ist Aufgabe der vorliegenden Erfindung, einen Gehäusekörper mit einer erhöhten Lebensdauer anzugeben. Insbesondere soll auch bei vergleichsweise kurzen Wellenlängen unter 500 nm eine Degradation des Gehäusekörpers vermieden werden. Diese Aufgabe wird durch einen Gehäusekörper gemäß Patentanspruch 1 gelöst.

Ferner ist es Aufgabe der Erfindung, ein seitlich emittierendes Bauelement mit einer erhöhten Lebensdauer anzugeben, das insbesondere auch bei vergleichsweise kurzen Wellenlängen unter 500 nm gegenüber einer Degradation unempfindlich ist. Diese Aufgabe wird durch seitlich emittierende Bauelement gemäß der Patentansprüche 11 und 12 gelöst.

Weiterhin ist es Aufgabe der Erfindung, ein Herstellungsverfahren für einen solchen Gehäusekörper anzugeben. Diese Aufgabe wird durch ein Verfahren gemäß Patentanspruch 17 gelöst.

Der Gehäusekörper weist eine Oberseite, eine der Oberseite gegenüberliegende Unterseite und eine die Oberseite und die Unterseite verbindende Seitenfläche auf, die als Montagefläche vorgesehen ist, wobei der Gehäusekörper eine Mehrzahl von Schichten aufweist, die ein Keramikmaterial enthalten, und eine Haupterstreckungsrichtung der Schichten quer zur Montagefläche verläuft.

Der Schichtaufbau des Gehäusekörpers aus einer Mehrzahl von Schichten, die ein Keramikmaterial enthalten, ermöglicht eine besonders einfache Herstellung desselben. Die Schichten können als Grünfolien aufeinander gestapelt und anschließend gesintert werden. Dabei ist unter einer Grünfolie eine ungesinterte Keramikschicht zu verstehen, die in diesem Zustand noch formbar ist, das heißt, sie kann beispielsweise durch Schneiden, Stanzen oder Prägen weiter verarbeitet werden. Durch das anschließende Sintern der Grünfolien kann eine gute Haftung zwischen den einzelnen Schichten erreicht werden. Damit lässt sich die Gefahr einer Schichtablösung verringern, was sich positiv auf die Stabilität beziehungsweise die Langlebigkeit des Gehäusekörpers auswirkt.

Die Schichten sind quer zur Montagefläche angeordnet. Besonders vorzugsweise sind die Schichten orthogonal zur Montagefläche angeordnet. Dies kann beispielsweise realisiert werden, indem die Schichten plan ausgebildet werden, und eine Unterseite einer ersten Schicht auf einer Oberseite einer der ersten Schicht nachgeordneten zweiten Schicht angeordnet wird. Diese Anordnung von Schichten kann beliebig oft fortgesetzt werden, wobei ein beliebig großer Schichtstapel gebildet werden kann. Eine Seitenfläche des so gebildeten Schichtstapels dient als Montagefläche des Gehäusekörpers.

Im Gegensatz zu herkömmlichen Gehäusekörpern soll sich der erfindungsgemäße Gehäusekörper außer für ein seitlich emittierendes Bauelement mit einer Strahlungsemission im infraroten oder sichtbaren Bereich, insbesondere auch für ein seitlich emittierendes Bauelement zur Emission von Strahlung im UV- beziehungsweise UV-nahen Bereich eignen, wobei die Wellenlänge der Strahlung vorzugsweise unter etwa 500 nm, besonders bevorzugt unter etwa 475 nm oder sogar 430 nm beträgt. Die Unempfindlichkeit des Gehäusekörpers gegenüber einer Degradation insbesondere durch UV-Strahlung wird durch das für den Gehäusekörper verwendete Material entscheidend mitbestimmt. Ein Keramikmaterial erweist sich gegenüber UV-Strahlung in der Regel als unempfindlich. Bevorzugt enthält der erfindungsgemäße Gehäusekörper ein UV-stabiles Material, besonders bevorzugt Al₂O₃ oder AlN. Diese beiden Materialien erweisen sich auch im Hinblick auf einen Abtransport der im Betrieb entstehenden Wärme aus dem Gehäusekörper zur Vermeidung thermisch bedingter Ausfälle als äußerst vorteilhaft, da ihre Wärmeleitfähigkeit vergleichsweise groß ist. So beträgt beispielsweise die Wärmeleitfähigkeit von Al₂O₃ bei Temperaturen zwischen 30 und 100°C zirka 18 bis 30 W/mK und von AlN zirka 30 bis 180 W/mK. Herkömmliche Kunststoffe weisen demgegenüber eine Wärmeleitfähigkeit auf, die oftmals unter 1 W/mK liegt.

Die oben genannten Punkte, nämlich eine reduzierte Gefahr der Schichtablösung, ferner eine verminderte Degradation bei UV- oder UV-naher Strahlung und schließlich ein verbesserter Wärmeabtransport tragen maßgeblich zur Langlebigkeit des Gehäusekörpers und bei einer Verwendung des Gehäusekörpers für ein seitlich emittierendes Bauelement zu einer verbesserten Betriebsdauer desselben bei.

Der Gehäusekörper weist elektrisch leitende Chipanschlussbereiche auf. So ist ein erster elektrisch leitender Chipanschlussbereich ein Drahtanschlussfeld. Ferner ist ein zweiter elektrisch leitender Anschlussbereich ein Chipfeld. Somit können bei einer Anordnung von Strahlung erzeugenden Halbleiterchips in dem Gehäusekörper die Halbleiterköper angeschlossen sein, indem sie mittels Leitern, vorzugsweise mittels Drahtverbindungen, mit den Drahtanschlussfeldern verbunden und ferner auf den Chipfeldern montiert sind. Dabei bilden die Drahtanschlussfelder einen ersten und die Chipfelder je einen zweiten elektrischen Kontakt für die Halbleiterkörper.

Jeder Chipanschlussbereich kann direkt auf einer der ein Keramikmaterial enthaltenden Schichten aufgebracht sein. Die Drahtanschlussfelder sind auf einer ersten Schicht angeordnet, während die Chipfelder auf einer von der ersten Schicht verschiedenen zweiten Schicht angeordnet sind.

Dabei kann jeder Chipanschlussbereich eine geringe Dicke aufweisen. Vorzugsweise liegt die Dicke im Bereich zwischen 10⁻⁶ m und 10⁻⁵ m, besonders vorzugsweise beträgt die Dicke 8 µm. Die Chipanschlussbereiche müssen nicht als Träger beziehungsweise selbsttragend ausgebildet sein, so dass an die Chipanschlussbereiche keine besonderen mechanischen Stabilitätsanforderungen gestellt werden. Es muss lediglich die elektrische Leitfähigkeit gewährleistet sein, was zweckmäßigerweise durch die Verwendung eines Metalls erreicht wird. Vorteilhafterweise lässt sich durch die geringe Dicke der Chipanschlussbereiche und von Leiterbahnen, die mit den Chipanschlussbereichen verbunden sind, eine geringe Gesamthöhe des Bauelements realisieren.

Vorzugsweise sind die Chipanschlussbereiche je in Form einer metallhaltigen Flüssigkeit oder Paste, besonders vorzugsweise in Form einer Metalltinte, auf eine Keramik enthaltende Schicht aufgetragen und ausgehärtet. Beispielweise kann die Flüssigkeit oder Paste Wolfram enthalten. Besonders vorzugsweise wird die Flüssigkeit oder Paste auf die Schicht aufgedruckt und ausgehärtet.

Für die Ablösungsgefahr der Chipanschlussbereiche gilt das bereits oben erwähnte: Die Keramik enthaltenden Schichten können mit den Chipanschlussbereichen gesintert werden, wodurch eine der Ablösung vorbeugende Haftung entsteht.

Der Gehäusekörper weist elektrisch leitende Durchkontaktierungen ("Vias") auf. Die Durchkontaktierungen verlaufen von der Strahlungsaustrittsseite, entlang der Montagefläche, zur Unterseite. Vorzugsweise sind die Durchkontaktierungen dabei derart angeordnet, dass sie je mit zumindest einer Leiterbahn, die eine Durchkontaktierung mit einem Chipanschlussbereich verbindet, elektrisch leitend verbunden sind. Die Leiterbahn kann zwischen zwei Keramikschichten angeordnet sein.

Die Durchkontaktierungen sind halbröhrenartig oder halbzylinderartig gestaltet, das heißt, dass die Form der Durchkontaktierungen je einer Röhre beziehungsweise einem Zylinder gleicht, die beziehungsweise der entlang der Mittelebene durchtrennt ist. Vorteilhafterweise kann diese Form einfach realisiert werden, indem vor dem Sintern quer zur Oberseite der Grünfolien in die Grünfolien eine zylinderförmige Vertiefung eingebracht wird. Anschließend kann die Vertiefung galvanisch mit einem metallhaltigen Material ausgekleidet oder gefüllt werden. Die zylinderförmige Vertiefung wird am Ende derart durchtrennt, dass eine halbröhrenartige oder halbzylinderartige Durchkontaktierung entsteht.

Vorteilhafterweise sind die Durchkontaktierungen auf der Oberseite und/oder Unterseite je von einer Metallisierung umgeben. Beispielsweise kann die Metallisierung bogenartig ausgebildet sein. Vorzugsweise passt sie sich je der Form der Durchkontaktierungen an. Die Metallisierung erleichtert bei einer Montage die genaue Positionierung des Gehäusekörpers auf einer Leiterplatte. Dies ist wichtig, damit der elektrische Anschluss gewährleistet ist. Ferner kann die Metallisierung dazu beitragen, dass sich der Gehäusekörper beim IR- oder Reflow-Löten selbst zentriert.

Der Gehäusekörper weist auf der Oberseite zur Aufnahme der Halbleiterchips eine Ausnehmung auf. Vorzugsweise ist die Ausnehmung derart angeordnet, dass die aus dem Bauelement emittierte Strahlung verlustarm in ein weiteres Element eingekoppelt werden kann. Beispielsweise ist das weitere Element ein Lichtleiter, der mit einem Träger verbunden sein kann. Hierfür kann die Ausnehmung an die der Montagefläche gegenüber liegende Seitenfläche näher heranreichen als an die Montagefläche.

Vorteilhafterweise ist die Ausnehmung als Reflektor ausgebildet. Beispielsweise kann sich die Ausnehmung ausgehend von der Oberseite in Richtung der Unterseite trichterförmig verjüngen. Ferner kann die Oberfläche der Ausnehmung mit einer reflexionserhöhenden Schicht bedeckt sein. Dadurch kann die Strahlung gebündelt und so die Intensität der seitlich emittierten Strahlung gesteigert werden.

Vorzugsweise beträgt eine Abmessung zwischen einem Rand der Ausnehmung und einem Rand des Gehäusekörpers etwa 0,3 mm. Besonders bevorzugt ist die Abmessung größer als 0,3 mm. Durch eine derartige Abmessung kann die durch den Gehäusekörper transmittierte Strahlung reduziert und einer nachteilhaften Strahlungsverteilung des seitlich emittierenden Bauelements vorgebeugt werden.

Die Handhabung des Gehäusekörpers kann durch eine geeignete Wahl des Verhältnisses der Höhe des Gehäusekörpers zur Dicke des Gehäusekörpers erleichtert werden. Unter der Höhe des Gehäusekörpers ist dabei die Abmessung der quer zur Montagefläche verlaufenden Kante zu verstehen. Unter der Dicke ist die Abmessung der quer zur Oberseite verlaufenden Kante zu verstehen. Vorzugsweise beträgt das Verhältnis der Höhe zur Dicke zwischen 1:1 und 2:1.

Dabei kann durch ein Verhältnis größer als 1:1 eine Verkippung des Gehäusekörpers in einem Verpackungsgurt vermieden werden. Ferner kann durch die Beachtung der oberen Grenze eine ausreichende Standfestigkeit des Gehäusekörpers gewährleistet werden, so dass die Gefahr eines Umkippens des Gehäusekörpers bei der Montage vorteilhaft gering ist. Das angegebene Verhältnis bezieht sich auf einen Gehäusekörper, bei dem alle Seitenflächen etwa im rechten Winkel zueinander angeordnet sind.

Der Gehäusekörper kann für ein seitlich emittierendes Bauelement verwendet werden. Zum Zwecke der Strahlungserzeugung weist das seitlich emittierende Bauelement drei Strahlungsquellen, also strahlungsemittierende Halbleiterchips auf, die in der Ausnehmung angeordnet sind.

Bei einer bevorzugten Ausführungsform sind in der Ausnehmung drei Halbleiterchips angeordnet, die Strahlung unterschiedlicher Wellenlänge emittieren. Bei entsprechender Wahl der Wellenlänge kann durch Mischung der Strahlung neben mehrfarbigem Licht auch mischfarbiges, vorzugsweise weißes Licht erzeugt werden. Dies dehnt den Rahmen der Anwendungsmöglichkeiten für das seitlich emittierende Bauelement aus. Beispielsweise ist für eine Displayhinterleuchtung auch weißes Licht gewünscht.

Ferner kann mit Halbleiterchips, die Strahlung gleicher Wellenlänge emittieren, durch Verwendung eines Konversionselements ebenfalls mehrfarbiges oder auch mischfarbiges Licht erzeugt werden. Dabei ist das Konversionselement einem Halbleiterchip nachgeordnet und kann diesen beispielsweise formschlüssig umhüllen.

Weiterhin ist eine Kombination eines Konversionselements mit Halbleiterchips, die Strahlung unterschiedlicher Wellenlänge erzeugen, denkbar.

Die Halbleiterchips können von einem Umhüllungsmaterial, vorzugsweise von einem Silikonharz oder einem geeigneten UV-stabilen Epoxidharz, umgeben sein. Außerdem sind Mischungen aus einem Silikonharz und einem UV-stabilen Epoxidharz oder aus sonstigen UV-stabilen Materialien beziehungsweise Harzen denkbar.

Das Umhüllungsmaterial kann sowohl als Schutz vor negativen mechanischen Einwirkungen als auch zur Reduzierung von Reflektionsverlusten an der Grenze zwischen Halbleiterchip und Umgebung dienen. Vorteilhafterweise können also durch die Verwendung eines geeigneten Umhüllungsmaterials die Betriebsdauer des strahlungsemittierenden Bauelements und zugleich die Auskopplungseffizienz erhöht werden.

Bei einer vorteilhaften Ausführungsform kann den Halbleiterchips zur weiteren Strahlformung beziehungsweise -bündelung ein optisches Element, vorzugsweise eine Linse, nachgeordnet sein. Das optische Element kann in der Ausnehmung angeordnet sein und/oder aus der Ausnehmung herausragen.

Vorzugsweise ist der Gehäusekörper beziehungsweise das seitlich emittierende Bauelement auf einer Leiterplatte montiert. Vorteilhafterweise kann sowohl die elektrische Versorgung des Gehäusekörpers beziehungsweise des seitlich emittierenden Bauelements als auch der Wärmeabtransport aus dem seitlich emittierenden Bauelement über die Leiterplatte erfolgen.

Für die elektrische Versorgung ist die Leiterplatte mit Leiterbahnen versehen, die derart angeordnet sind, dass sie eine möglichst einfache elektrische Verbindung der Leiterbahnen mit den Durchkontaktierungen ermöglichen. Beispielsweise können die Leiterbahnen der Leiterplatte geradlinig verlaufen.

Ferner kann die Leiterplatte zur Kühlung des Gehäusekörpers ein gut wärmeleitendes Material enthalten. Beispielsweise ist die Leiterplatte eine Metallkernplatine. Für einen optimalen Transport der im Gehäusekörper beziehungsweise seitlich emittierenden Bauelements erzeugten Wärme zur Leiterplatte sind ausreichend große wärmeleitende Flächen, beispielsweise lötbare Flächen, auf der Unterseite des Gehäusekörpers vorgesehen. Die Flächengröße kann sich aus der Größe einer einzigen zusammenhängenden Fläche oder aus der Summe der Größe einer Mehrzahl unzusammenhängender Flächen ergeben.

Bei einem Verfahren zur Herstellung eines solchen Gehäusekörpers mit einer Oberseite, mit einer der Oberseite gegenüber liegenden Unterseite und mit einer die Oberseite und die Unterseite verbindenden Seitenfläche, die als Montagefläche vorgesehen ist, der eine Mehrzahl von Schichten aufweist, die ein Keramikmaterial enthalten, wird eine Platte in eine Mehrzahl von Gehäusekörpern vereinzelt. Damit lässt sich ein Gehäusekörper besonders einfach herstellen.

Diese Herstellungsweise begünstigt die Serienproduktion von Gehäusekörpern und seitlich emittierenden Bauelementen, wodurch sich im Vergleich zur Einzelfertigung Kosten einsparen lassen.

Vorzugsweise ist die Platte aus einem Keramikschichtstapel gebildet. Dabei weist sie vorteilhafterweise auf einer Oberseite Ausnehmungen auf. Die Oberseite entspricht nach der Vereinzelung der Platte in eine Mehrzahl von Gehäusekörpern der Oberseite eines Gehäusekörpers. Besonders vorzugsweise gleichen sich die Gehäusekörper in Form und Größe, so dass eine regelmäßige Anordnung der Ausnehmungen auf der Oberseite von Vorteil ist.

Vorzugsweise weist die Platte eine plane Oberseite auf. Dabei können die Ausnehmungen wie die Gitterpunkte eines Gitters auf der Oberseite verteilt sein.

Der Gehäusekörper weist auf der Montagefläche halbröhrenartige oder halbzylinderartige Durchkontaktierungen auf. Vorteilhafterweise wird zu deren Herstellung die Platte mit röhrenartigen oder zylinderartigen Durchkontaktierungen versehen vorzugsweise, indem vor dem Sintern in die Grünfolien zunächst röhrenartige oder zylinderartige Vertiefungen eingebracht werden. Diese Vertiefungen können mittels Galvanisierung mit einer elektrisch leitenden Schicht ausgekleidet oder mit einem elektrisch leitenden Material, vorzugsweise einem Metall, gefüllt werden. Dabei ist auf einen genügend großen Abstand zwischen den Durchkontaktierungen zu achten, um beispielsweise bei der Verwendung des Gehäusekörpers für ein seitlich emittierendes Bauelement bei einem späteren Betrieb einen Kurzschluss zu vermeiden.

Die so gebildeten Durchkontaktierungen werden bei der Vereinzelung auf effiziente Weise freigelegt. Dies wird bei der Erfindung dadurch erreicht, dass die Durchkontaktierungen, die vorzugsweise zwischen zwei benachbarten Ausnehmungen entlang parallel verlaufender Geraden angeordnet sind, durchtrennt werden. Die Platte kann entlang der parallel verlaufenden Geraden getrennt werden. Besonders vorzugsweise wird die Platte derart vereinzelt, dass die Durchkontaktierungen asymmetrisch durchtrennt werden.

Die asymmetrische Durchtrennung entlang einer Geraden wird vorteilhafterweise so durchgeführt, dass ein erster Gehäusekörper auf der Montagefläche für die elektrische Leitung gut ausgebildete Durchkontaktierungen aufweist, während ein an den ersten Gehäusekörper angrenzender zweiter Gehäusekörper auf der der Montagefläche gegenüber liegenden Seitenfläche in der Regel keine beziehungsweise Reste der durchtrennten Durchkontaktierungen aufweist.

Vor der Durchtrennung grenzt die spätere Montagefläche des ersten Gehäusekörpers an die der Montagefläche gegenüberliegende spätere Seitenfläche des zweiten Gehäusekörpers. Diese Art der Durchtrennung ist äußerst effizient, da bei der Vereinzelung der Platte kein Verschnitt anfällt. Ferner kann dadurch die Herstellungsdauer minimiert werden, weil die Gehäusekörper nach der Durchtrennung in der richtigen Größe vorliegen, wodurch eine Nachbearbeitung entfällt.

Eine bevorzugte Methode zur asymmetrischen Durchtrennung ist das asymmetrische Durchsägen der Platte, vorzugsweise entlang der parallelen Geraden. Dabei ist darauf zu achten, dass an der späteren Montagefläche des ersten Gehäusekörpers im wesentlichen eine obere Hälfte der Durchkontaktierungen erhalten bleibt, während im wesentlichen eine untere Hälfte der Durchkontaktierungen durch eine Sägespur entfernt wird, so dass auf der der Montagefläche gegenüber liegenden späteren Seitenfläche des zweiten Gehäusekörpers eine glatte ebene Fläche erzeugt wird. Es ist von Vorteil, wenn diese Seitenfläche, die bei einer Bestückung als Ansaugfläche dienen kann, besonders glatt ausgebildet ist, da sie dann leichter ansaugbar ist.

Vorzugsweise kann vor der Vereinzelung der Platte in jeder Ausnehmung mindestens ein strahlungsemittierender Halbleiterchip montiert werden.

Nach der Herstellung kann der Gehäusekörper auf einer Leiterplatte angeordnet werden und zwar so, dass die Durchkontaktierungen von Leiterbahnen der Leiterplatte kontaktiert werden.

Vorteilhafterweise kann das seitlich emittierende Bauelement für Anwendungen verwendet werden, bei denen eine geringe Bauteilhöhe erwünscht ist. Denn durch die seitliche Abstrahlung kann das Bauelement in einer horizontalen Ebene mit einem zu beleuchtenden Element seitlich von diesem angeordnet werden. Bei einem vertikal abstrahlenden Bauelement hingegen ist es dem zu beleuchtenden Element in vertikaler Richtung nachzuordnen, wodurch sich die Gesamthöhe des Bauteils erhöhen kann. Ferner begünstigt ein seitlich emittierendes Bauelement die Lichteinkopplung in einen beispielsweise plan ausgebildeten Lichtleiter.

Beispielsweise kann ein seitlich emittierendes Bauelement zur Hinterleuchtung von Handydisplays, Handytastaturen oder LCDs verwendet werden. Ferner kann es in Navigationssystemen, Blinkern oder bei Hochtemperaturanwendungen vorteilhafte Verwendung finden.

Weitere Merkmale, Vorteile und Weiterbildungen der Erfindung ergeben sich aus den nachfolgend in Verbindung mit den Figuren 1 bis 7 erläuterten Ausführungsbeispielen.

Es zeigen:
- Figur 1a, 1b und 1c: eine schematische Vorderansicht, eine schematische Querschnittsansicht und eine schematische Rückansicht eines ersten Ausführungsbeispiels eines erfindungsgemäßen Gehäusekörpers,
- Figur 2a, 2b, 2c und 2d: eine schematische Vorderansicht, eine schematische Querschnittsansicht, eine schematische Längsschnittansicht und eine schematische Rückansicht einer ersten Schicht des erfindungsgemäßen Gehäusekörpers gemäß dem ersten Ausführungsbeispiel,
- Figur 3a, 3b und 3c: eine schematische Vorderansicht, eine schematische Querschnittsansicht und eine schematische Rückansicht einer zweiten des erfindungsgemäßen Gehäusekörpers gemäß dem ersten Ausführungsbeispiel,
- Figur 4a, 4b und 2c: eine schematische Vorderansicht, eine schematische Querschnittsansicht und eine schematische Rückansicht einer dritten Schicht des erfindungsgemäßen Gehäusekörpers gemäß dem ersten Ausführungsbeispiel,
- Figur 5: eine schematische Aufsicht auf eine Platte, aus der vier Gehäusekörper vereinzelt werden,
- Figur 6: eine schematische dreidimensionale Ansicht eines Ausführungsbeispiels eines erfindungsgemäßen seitlich emittierenden Bauelements,
- Figur 7: ein auf eine Leiterplatte montierter Gehäusekörper.

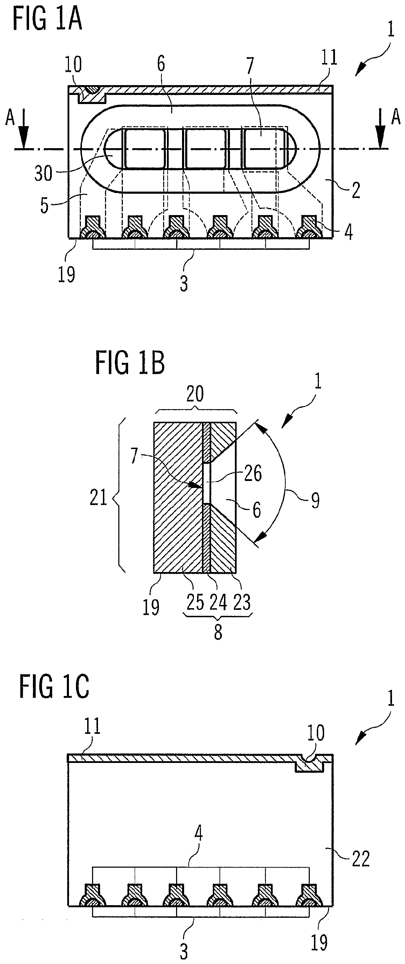

Die in Figur 1a gezeigte Oberseite 2 des Gehäusekörpers 1 bildet eine Strahlungsaustrittsseite eines strahlungsemittierenden Bauelements. Die Oberseite 2 ist die Vorderseite einer ersten Schicht, die mit einer der ersten Schicht nachgeordneten zweiten und dritten Schicht einen Schichtstapel bildet, den der Gehäusekörper 1 umfasst.

Die erste Schicht weist eine Ausnehmung 6 auf, die sich ausgehend von der Oberseite 2 in Richtung der zweiten Schicht verjüngt.

Bei dem in Figur 1a dargestellten Gehäusekörper 1 sind in der Ausnehmung 6 drei Chipfelder 7 vorgesehen. Auf jedem Chipfeld 7 kann eine Strahlungsquelle, vorzugsweise ein strahlungsemittierender Halbleiterchip, angeordnet sein. Für einen elektrischen Anschluss jedes Chips ist jeweils ein Drahtanschlussfeld 30 und ein Chipfeld 7 vorgesehen. Des Weiteren ist je eine Durchkontaktierung 3 vorgesehen, die mittels einer Leiterbahn 5 mit einem Drahtanschlussfeld 30 oder einem Chipfeld 7 verbunden ist.

Vorzugweise enthalten die Durchkontaktierungen 3 ein Metall, besonders vorzugsweise Wolfram. Die Durchkontaktierungen 3 sind halbkreisförmig ausgebildet. Sie verlaufen entlang der Montagefläche 19 von der Oberseite 2 zu der der Oberseite 2 gegenüber liegenden Unterseite. Die Durchkontaktierungen 3 können gebildet werden, in dem in den drei verschiedenen Schichten Vertiefungen ausgespart werden, die zum Beispiel mittels Galvanisierung mit Wolfram ausgekleidet oder gefüllt werden. Dabei kann die Metallschicht 11 als Elektrode dienen.

In Figur 1a sind sechs Durchkontaktierungen 3 dargestellt, von denen jeweils zwei benachbarte elektrisch leitend mit je einem Halbleiterchip verbunden sind. Ferner bilden die jeweils zwei benachbarten Durchkontaktierungen 3 jeweils einen ersten und zweiten elektrischen Kontakt. Vorteilhafterweise ist jeder Halbleiterchip separat ansteuerbar. Alternativ können die Halbleiterchips seriell oder parallel verschaltet werden.

Die die Durchkontaktierungen 3 auf der Oberseite 2 umgebenden Metallisierungen 4 können wie die Metallisierung 10 dem Zwecke der Markierung dienen. Mit Hilfe der durch die Metallisierung 4 gekennzeichneten Position der Durchkontaktierung 3 kann bei einer Montage des Gehäusekörpers 1 auf eine Leiterplatte eine elektrische Verbindung der Durchkontaktierungen 3 mit auf der Leiterplatte angeordneten Leiterbahnen erleichtert werden. Ebenso kann die Orientierung des Gehäusekörpers 1 durch die Metallisierung 10 leichter festgestellt werden.

Ferner können die Metallisierungen 4 dazu beitragen, dass sich der Gehäusekörper 1 beim IR- oder Reflow-Löten selbst zentriert.

Die horizontale Linie A-A bildet die Mittelachse der Ausnehmung 6 und verläuft parallel zur Montagefläche 19. Sie ist von der Montagefläche 19 weiter entfernt als von der der Montagefläche 19 gegenüber liegenden Seitenfläche. Die dezentrierte Anordnung der Ausnehmung 6 hat den Vorteil, dass eine effiziente Einkopplung der emittierten Strahlung beispielsweise in einen Lichtleiter erleichtert wird.

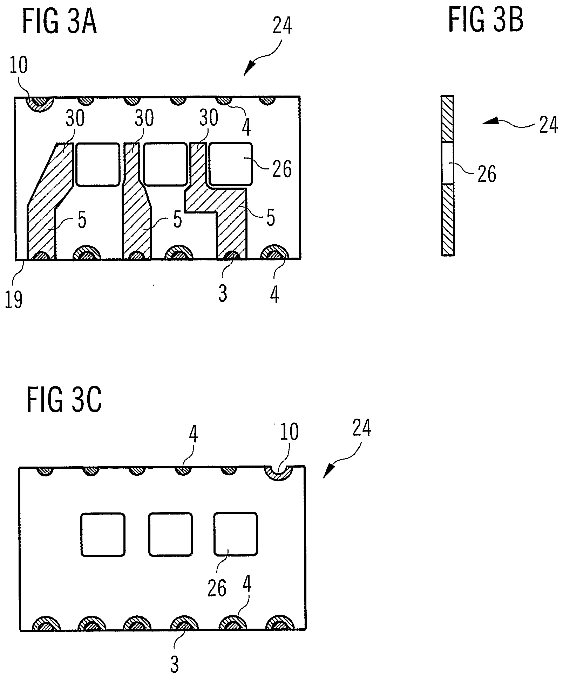

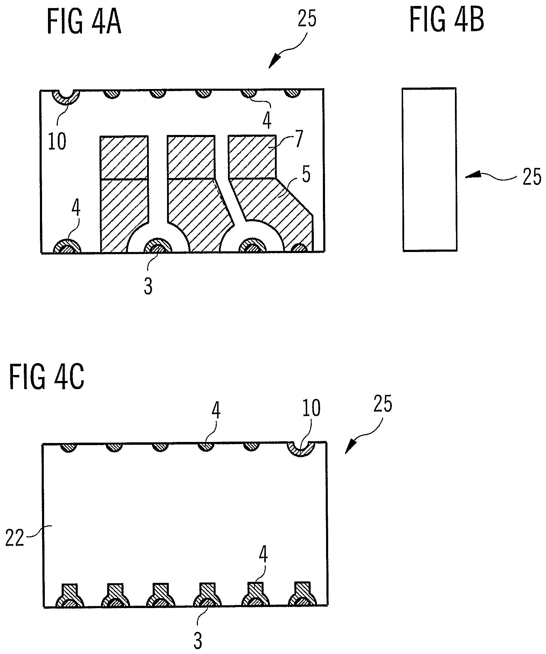

Die gestrichelt dargestellten Figurenbestandteile sind Elemente der zweiten und dritten Schicht und werden im Zusammenhang mit den Figuren 3 und 4 näher erläutert.

In Figur 1b ist die Querschnittsansicht des Gehäusekörpers 1 schematisch dargestellt. Zu erkennen ist ein Schichtstapel 8, der die drei Schichten 23, 24, 25 umfasst, die ein Keramikmaterial enthalten.

Die Schicht 23 weist die Ausnehmung 6 auf, die vorteilhafterweise als Reflektor ausgebildet ist. An den Reflektor wird die Anforderung gestellt, die von den in der Ausnehmung 6 angeordneten Halbleiterchips emittierte Strahlung derart zu bündeln, dass das seitlich emittierende Bauelement eine besonders hohe Strahlungsausbeute aufweist. Dies kann beispielsweise durch einen Öffnungswinkel 9 von 90° erreicht werden.

Die Schicht 24 weist die Chipvertiefung 26 auf, die in ihrer Größe an die Größe der Halbleiterchips, die in der Vertiefung auf dem Chipfeld 7 angeordnet sind, angepasst ist.

Die Schicht 25 kann beispielsweise zur Kühlung des Bauelements und damit zu dessen Stabilität beitragen. Je dicker diese Schicht ist, desto mehr Wärme kann absorbiert werden.

Für eine spätere Montage des Gehäusekörpers 1 zum Beispiel auf einer Leiterplatte ist das Verhältnis der Höhe 21 zur Dicke 20 zu beachten. Vorteilhafterweise beträgt das Verhältnis 2:1. Beispielsweise kann die Höhe 3,2 mm und die Dicke 1,65 mm betragen.

In Figur 1c ist die der Oberseite 2 gegenüber liegende Unterseite 22 schematisch dargestellt. Die Unterseite 22 weist die die Durchkontaktierungen 3 umgebenden Metallisierungen 4 und die Metallisierung 10, die als Markierungen zur Orientierung des Gehäusekörpers 1 dienen, und die als Elektrode dienende Metallschicht 11 auf.

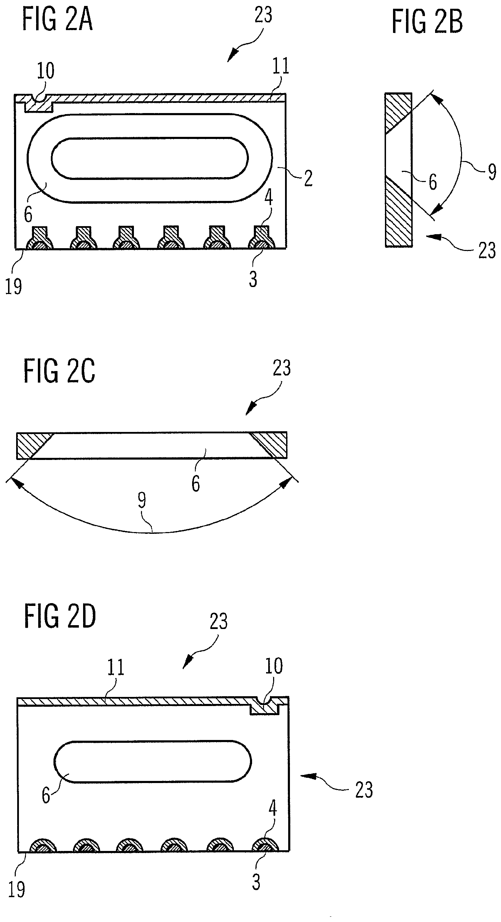

In Figur 2 ist die Schicht 23 des Gehäusekörpers 1 in verschiedenen Ansichten schematisch dargestellt.

Die Schicht 23 dient insbesondere der Strahlführung. Dazu weist sie die Ausnehmung 6 auf, durch die die von der unter der Ausnehmung 6 beziehungsweise innerhalb der Ausnehmung (vergleiche Figur 1a) angeordneten Strahlungsquellen erzeugte Strahlung aus dem seitlich emittierenden Bauelement austritt. Die Strahlführung kann vorteilhafterweise durch die Form der Ausnehmung 6 beeinflusst werden.

In Figur 2a ist die Oberseite 2 des Gehäusekörpers 1, die zugleich die Strahlungsaustrittsseite des seitlich emittierenden Bauelements bildet, gezeigt. Dargestellt sind die Durchkontaktierungen 3, die Metallisierungen 4 und 10, die Elektrode 11 und die Ausnehmung 6. Die Ausnehmung 6 kann wie dargestellt oval geformt sein. Außerdem kann sie sich von der Vorderseite bis zur Rückseite der Schicht 23 trichterförmig verjüngen.

In Figur 2b ist die Schicht 23 im Querschnitt schematisch dargestellt. Die Schicht 23 enthält ein Keramikmaterial. Bei der Herstellung kann die Schicht 23 teilweise ausgehöhlt werden, sodass die Ausnehmung 6 entsteht. Die Ausnehmung 6 gleicht dabei einem Kegelstumpf. Sie eignet sich als Reflektor, wobei der Öffnungswinkel 9 vorzugsweise 90° beträgt. Ebenso beträgt der Öffnungswinkel 9 der in der Figur 2c im Längsschnitt dargestellten Ausnehmung 6 vorzugsweise 90°.

In Figur 2d ist die Rückseite der Schicht 23 dargestellt. Während die Metallisierungen 4 und 10 und die Metallschicht 11 auf der Vorder- und der Rückseite der Schicht 23 aufgebracht sind, erstrecken sich die Durchkontaktierungen 3 von der Vorderseite bis zur Rückseite und verlaufen dabei entlang der Montagefläche 19.

In Figur 3 ist die Schicht 24 des Gehäusekörpers 1 in verschiedenen Ansichten schematisch dargestellt.
In Figur 3a ist die Vorderseite der Schicht 24 gezeigt. Diese Vorderseite ist im Schichtstapel der Rückseite der Schicht 23 zugewandt. Die Schicht 24 weist auf der Vorderseite elektrisch leitfähige Drahtanschlussfelder 30 auf. Jedes Drahtanschlussfeld 30 ist mit einer Leiterbahn 5 verbunden, wobei die Leiterbahn 5 an eine Durchkontaktierung 3 grenzt. An der Grenze zu der Durchkontaktierung 3 ist die Leiterbahn 5 so ausgebildet, dass sich die Durchkontaktierung 3 passgenau in die Leiterbahn 5 fügt. Vorzugsweise ist die Durchkontaktierung 3 an der Grenze zu der Leiterbahn 5 halbkreisförmig ausgebildet, während die Leiterbahn 5 eine halbkreisförmige Ausbuchtung aufweist.

Über die Leiterbahnen 5 kann ein elektrischer Anschluss zu Halbleiterchips hergestellt werden, für die die Chipvertiefungen 26 vorgesehen sind. Jeder Halbleiterchip ist mittels eines Drahtes mit einem für den jeweiligen Halbleiterchip vorgesehenen Drahtanschlussfeld 30 verbunden.

Die Leiterbahnen 5 sind durch die Schicht 23 bedeckt, während die Drahtanschlussfelder 30 in der Ausnehmung 6 freiliegen.

Die Chipvertiefungen 26 sind in die Schicht 24 eingebracht. Vorzugsweise entspricht ihre Größe der Größe der Chips.

In Figur 3a sind auf der der Montagefläche 19 abgewandten Seite der Vorderseite Reste von Metallisierungen 4 zu erkennen. Diese sind das Ergebnis der oben beschriebenen asymmetrischen Durchtrennung der Platte zur Herstellung einzelner Bauelemente.

In Figur 3b ist ein Querschnitt der Schicht 24 schematisch dargestellt. Vorzugsweise erstreckt sich die Chipvertiefung 26 von der Vorderseite bis zur Rückseite der Schicht 24. Besonders vorzugsweise bildet die Chipvertiefung 26 etwa eine quaderförmige Vertiefung.

In Figur 3c ist die Rückseite der Schicht 24 schematisch dargestellt. Diese weist die als Markierung dienenden Metallisierungen 4 und 10 auf, außerdem die Chipvertiefungen 26 und die Durchkontaktierung 3.

In Figur 4 ist die Schicht 25 in verschiedenen Ansichten schematisch dargestellt.

In Figur 4a ist die Vorderseite der Schicht 25 schematisch dargestellt. Diese Vorderseite ist der Rückseite der Schicht 24 zugewandt, wobei die Rückseite die Vorderseite nahezu vollständig bedeckt. Lediglich die Chipvertiefungen 26 bilden Fenster zur Schicht 25. Durch diese Fenster sind die Chipfelder 7 zu sehen. Auf den Chipfeldern 7 können Chips angeordnet werden. Die Leiterbahnen 5 stellen eine elektrische Verbindung zwischen den Chipfeldern 7 und den Durchkontaktierungen 3 her. Die Leiterbahnen 5 der Schicht 25 grenzen dabei an andere Durchkontaktierungen 3 als die Leiterbahnen 5 der Schicht 24.

In dem in Figur 4a dargestellten Ausführungsbeispiel können drei Chips auf drei separaten Chipfeldern 7 angeordnet werden, wobei die Chips separat ansteuerbar sind.

In Figur 4b ist ein Querschnitt der Schicht 25 schematisch dargestellt. Die Schicht 25 kann eine Wärmesenke bilden. Dabei erweist sich das vorzugsweise in der Schicht 25 enthaltene Keramikmaterial als vorteilhaft.

In Figur 4c ist die Rückseite der Schicht 25 schematisch dargestellt, die zugleich die Unterseite 22 des Gehäusekörpers 1 bildet.

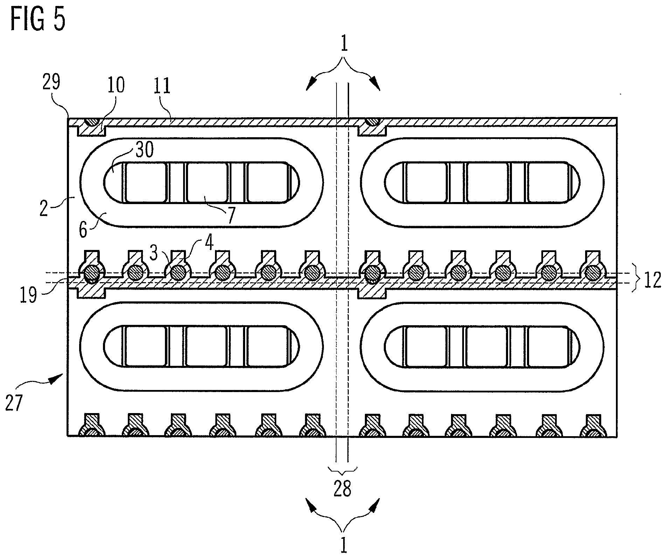

In Figur 5 ist eine Platte 27 dargestellt, die in vier Gehäusekörper 1 vereinzelt wird. Vorzugsweise ist die Platte 27 aus einem Keramikschichtstapel gebildet. Besonders vorzugsweise umfasst der Schichtstapel drei Schichten. Die drei Schichten können entsprechend den in den Figuren 2 bis 4 dargestellten Schichten 23, 24, 25 ausgebildet sein.

Somit kann die erste Schicht der Platte 27 die trichterförmige Ausnehmung 6 aufweisen, die sich von der Oberseite, die die spätere Oberseite 2 des Gehäusekörpers 1 bildet, bis zur Rückseite der ersten Schicht erstreckt. Der ersten Schicht sind die zweite und die dritte Schicht nachgeordnet. Von der zweiten Schicht sind die Drahtanschlussfelder 30 und von der dritten Schicht die Chipfelder 7 erkennbar.

Vorzugsweise sind die auf der Platte 27 aufgebrachten Metallisierungen 4 längs einer Geraden 12 angeordnet. Die Platte 27 kann entlang dieser Geraden 12 durchtrennt werden. Vorteilhafterweise wird die Platte 27 so durchtrennt, dass auf der Seitenfläche 29 die Durchkontaktierungen 3 im wesentlichen entfernt werden, während sie auf der Montagefläche 19 freigelegt werden. Dadurch erhält der Gehäusekörper 1 ausschließlich auf der Montagefläche 19 elektrische Anschlussmöglichkeiten. Die Seitenfläche 29 wird zum Zwecke einer späteren Montage des Gehäusekörpers 1, zum Beispiel auf einer Leiterplatte, geglättet, damit dieses leicht bestückbar ist. Beispielsweise kann die Platte 27 entlang der Geraden 12 zersägt werden, wobei die Sägespur vorteilhafterweise entsprechend der Breite der Geraden 12 gewählt wird.

Eine weitere Durchtrennung kann entlang der Linie 28 durchgeführt werden, wobei die Platte 27 dabei beispielsweise mittels Brechen durchtrennt werden kann.

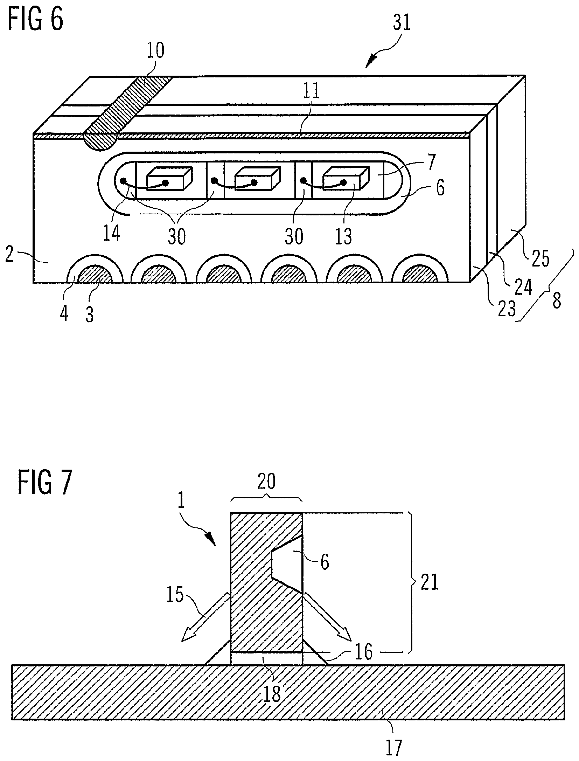

In Figur 6 ist beispielhaft ein aus der Platte 27 vereinzelbares, seitlich emittierende Bauelement 31 perspektivisch dargestellt. Es weist einen Schichtstapel auf, der vorzugsweise die Schicht 23, die Schicht 24 und die Schicht 25 umfasst. Die Schicht 23 ist mit der Ausnehmung 6 versehen. In der Ausnehmung 6 ist auf jedem Chipfeld 7 ein Chip 13 angeordnet, der mittels eines Leiters 14 an ein Drahtanschlussfeld 30 angeschlossen ist. Vorzugsweise sind die Chips 13 mit einem elektrisch leitfähigen Kleber auf die Chipfelder 7 aufgebracht.

Die Halbleiterchips 13 können sich beispielsweise durch die Wellenlänge der emittierten Strahlung unterscheiden. Die Wellenlänge kann beispielsweise im roten, grünen beziehungsweise blauen Spektralbereich liegen.

In Figur 7 ist ein Gehäusekörper 1 dargestellt, der auf einer Leiterplatte 17 montiert ist. Die Handhabung des Gehäusekörpers 1 bei der Montage kann erleichtert werden, wenn ein Verhältnis der Höhe 21 zur Dicke 20 von 2:1 gewählt wird. Beim Löten wirken Kippkräfte 15 auf den Gehäusekörper 1. Diesen Kräften kann beispielsweise durch die Aufbringung symmetrisch angeordneter Lotkehlen 16 entgegengewirkt werden. Die Metallschicht 18 kann vorteilhafterweise die Funktion einer elektrisch leitenden und/oder wärmeleitenden Verbindung zwischen dem Gehäusekörper 1 und der Leiterplatte 17 erfüllen.

Es sei darauf hingewiesen, dass sich die Schichten 23, 24 und 25 aus mehreren Teilschichten zusammensetzen können.

## Patentansprüche

1. Gehäusekörper (1) mit einer Oberseite (2), mit einer der Oberseite (2) gegenüberliegenden Unterseite (22) und mit einer die Oberseite (2) und die Unterseite (22) verbindenden Seitenfläche, die als Montagefläche (19) zur Montage auf einer Leiterplatte vorgesehen ist, wobei
der Gehäusekörper (1) eine Mehrzahl von Schichten (8) aufweist, die ein Keramikmaterial enthalten, und eine Haupterstreckungsrichtung der Schichten (23, 24, 25) quer zur Montagefläche (19) verläuft, wobei der Gehäusekörper (1) elektrisch leitende Chipanschlussbereiche für Halbleiterchips aufweist, wobei
- jeweils ein erster elektrisch leitender Chipanschlussbereich ein Drahtanschlussfeld (30) ist, das zur Verbindung mit einem elektrischen Leiter eingerichtet ist,
- jeweils ein zweiter elektrisch leitender Chipanschlussbereich ein Chipfeld (7) ist, das zur Montage eines Halbleiterchips eingerichtet ist,
- die Drahtanschlussfelder (30) auf einer ersten Schicht (24) und die Chipfelder (7) auf einer zweiten Schicht (25) angeordnet sind,
- der Gehäusekörper elektrisch leitende Durchkontaktierungen (3) aufweist, und
- die Durchkontaktierungen (3) jeweils halbröhrenförmig oder halbzylinderförmig sind,
**dadurch gekennzeichnet, dass**
- der Gehäusekörper (1) für genau drei der Halbleiterchips eingerichtet ist,
- der Gehäusekörper (1) für die Halbleiterchips jeweils zwei benachbarte der elektrisch leitenden Durchkontaktierungen (3) aufweist, die jeweils von der Oberseite (2) zur Unterseite (22) verlaufen, und
- die Durchkontaktierungen (3) jeweils entlang der Montagefläche (19) verlaufen.

2. Gehäusekörper (1) nach Anspruch 1, wobei
das Keramikmaterial UV-stabil ist.

3. Gehäusekörper (1) nach einem der Ansprüche 1 oder 2, wobei
das Keramikmaterial Al₂O₃ ist.

4. Gehäusekörper (1) nach einem der Ansprüche 1 oder 2, wobei
das Keramikmaterial AlN ist.

5. Gehäusekörper (1) nach einem der vorhergehenden Ansprüche, wobei
die Durchkontaktierungen (3) auf der Oberseite (2) und/oder der Unterseite (22) von einer Metallisierung (4) umgeben ist.

6. Gehäusekörper (1) nach Anspruch 5, wobei die Metallisierung (4) bogenartig ausgebildet ist.

7. Gehäusekörper (1) nach einem der vorhergehenden Ansprüche, der auf der Oberseite (2) eine Ausnehmung (6) aufweist.

8. Gehäusekörper (1) nach Anspruch 7, wobei
die Ausnehmung (6) derart angeordnet ist, dass sie an die der Montagefläche (19) gegenüberliegende Seitenfläche (29) näher heranreicht als an die Montagefläche (19).

9. Gehäusekörper (1) nach einem der Ansprüche 7 oder 8, wobei
die Ausnehmung (6) als Reflektor ausgebildet ist.

10. Gehäusekörper (1) nach einem der vorhergehenden Ansprüche, wobei
das Verhältnis einer Höhe (21) zu einer Dicke (20) des Gehäusekörpers (1) zwischen 1:1 und 2:1 liegt.

11. Seitlich emittierendes Bauelement (31) mit einem Gehäusekörper (1) gemäß einem der Ansprüche 7 bis 10, wobei drei Halbleiterchips (13) in der Ausnehmung (6) angeordnet sind.

12. Seitlich emittierendes Bauelement (31) mit einem Gehäusekörper (1) gemäß einem der Ansprüche 7 bis 10, wobei drei Halbleiterchips (13) in der Ausnehmung (6) angeordnet sind, die Strahlung unterschiedlicher Wellenlänge emittieren.

13. Seitlich emittierendes Bauelement (31) nach einem der Ansprüche 11 oder 12, wobei
die Halbleiterchips mit einem Umhüllungsmaterial umhüllt sind.

14. Seitlich emittierendes Bauelement (31) nach einem der Ansprüche 11 bis 13, wobei
den Halbleiterchips ein optisches Element nachgeordnet ist.

15. Seitlich emittierendes Bauelement (31) nach einem der Ansprüche 11 bis 14, das
auf einer Leiterplatte (17) aufgebracht ist.

16. Seitlich emittierendes Bauelement (31) nach Anspruch 15, das
mit der Leiterplatte (17) elektrisch leitend und/oder wärmeleitend verbunden ist.

17. Verfahren zur Herstellung eines Gehäusekörpers (1) gemäß einem der Ansprüche 1 bis 10, wobei
der Gehäusekörper (1) dadurch hergestellt wird, dass eine Platte (27) in eine Mehrzahl von Gehäusekörpern (1) vereinzelt wird.

18. Verfahren nach Anspruch 17, bei dem
die Platte (27) einen Keramikschichtstapel (8) und auf einer Oberseite, die der Oberseite (2) des Gehäusekörpers (1) entspricht, eine Mehrzahl von regelmäßig angeordneten Ausnehmungen (6) aufweist, wobei
zwischen zwei benachbarten Ausnehmungen (6) die Durchkontaktierungen (3), die von der Oberseite (2) bis zur Unterseite (22) verlaufen, angeordnet sind, und
die Platte (27) derart in die Mehrzahl von Gehäusekörpern vereinzelt wird, dass die Durchkontaktierungen (3) asymmetrisch durchtrennt werden.

19. Verfahren nach Anspruch 18, wobei
die Durchkontaktierungen (3) durchgesägt werden.

20. Verfahren nach Anspruch 18 oder 19, wobei vor der Durchtrennung in der Ausnehmung (6) die drei Strahlung erzeugenden Halbleiterchips (13) angeordnet werden.

21. Verfahren nach einem der Ansprüche 18 bis 20, wobei der Gehäusekörper (1) auf einer Leiterplatte (27) derart angeordnet wird, dass die Durchkontaktierungen (3) von Leiterbahnen der Leiterplatte (17) kontaktiert werden.

## Claims

1. Housing body (1) having an upper side (2), having an underside (22) opposite the upper side (2) and having a side surface which connects the upper side (2) and the underside (22) and which is provided as a mounting surface (19) for mounting on a printed circuit board, wherein
the package body (1) comprises a plurality of layers (8) containing a ceramic material and a main extension direction of the layers (23, 24, 25) extends transversely to the mounting surface (19), wherein the housing body (1) comprises electrically conductive chip connection areas for semiconductor chips, wherein
- in each case a first electrically conductive chip connection area is a wire terminal panel (30) which is configured for connection to an electrical conductor,
- in each case a second electrically conductive chip connection area is a chip panel (7) which is configured for mounting a semiconductor chip,
- the wire terminal panels (30) are arranged on a first layer (24) and the chip panels (7) are arranged on a second layer (25),
- the housing body has electrically conductive through-contacts (3), and
- the through-contacts (3) are each semi-tubular or semicylindrical,
**characterized in that**
- the housing body (1) is configured for exactly three of the semiconductor chips,
- the housing body (1) comprises two of the electrically conductive through-contacts (3) for each semiconductor chip, said through-contacts (3) each run from the upper side (2) to the underside (22), and
- the through-contacts (3) each run along the mounting surface (19).

2. Housing body (1) according to claim 1, wherein
the ceramic material is UV-stable.

3. Housing body (1) according to one of claims 1 or 2, wherein the ceramic material is Al₂O₃.

4. Housing body (1) according to any of claims 1 or 2, wherein the ceramic material is AlN.

5. Housing body (1) according to one of the preceding claims, wherein the through-contact (3) are surrounded by a metallization (4) on the upper side (2) and/or the Underside (22).

6. Housing body (1) according to claim 5, wherein the metallization (4) is of arcuate design.

7. Housing body (1) according to one of the preceding claims, which has a recess (6) on the upper side (2).

8. Housing body (1) according to claim 7, wherein
the recess (6) is arranged such that it comes closer to the side surface (29) opposite the mounting surface (19) than to the mounting surface (19).

9. Housing body (1) according to one of the claims 7 or 8, wherein the recess (6) is designed as a reflector.

10. Housing body (1) according to one of the preceding claims, wherein
the ratio of a height (21) to a thickness (20) of the housing body (1) is between 1:1 and 2:1.

11. Side-emitting component (31) comprising a housing body (1) according to any one of claims 7 to 10, wherein
three semiconductor chips (13) are arranged in the recess (6) .

12. Side-emitting component (31) comprising a housing body (1) according to any one of claims 7 to 10, wherein
three semiconductor chips (13) are arranged in the recess (6), which emit radiation of different wavelengths.

13. Side-emitting component (31) according to one of claims 11 or 12, wherein the semiconductor chips are coated with a coating material.

14. Side-emitting component (31) according to any of claims 11 to 13, wherein an optical element is arranged downstream of the semiconductor chips.

15. Side-emitting component (31) according to any of claims 11 to 14 which is applied to a printed circuit board (17).

16. Side-emitting component (31) according to claim 15 which is electrically conductively and/or thermally conductively connected to the printed circuit board (17).

17. Method for producing a housing body (1) according to any one of claims 1 to 10, wherein
the housing body (1) is manufactured by separating a plate (27) into a plurality of housing bodies (1).

18. Method according to claim 17, in which
the plate (27) has a ceramic layer stack (8) and, on an upper side corresponding to the upper side (2) of the housing body (1), a plurality of regularly arranged recesses (6), wherein between two adjacent recesses (6) the through-contact (3) extending from the upper side (2) to the underside (22) are arranged, and
the plate (27) is separated into the plurality of housing bodies in such a way that the through-contacts (3) are cut-through asymmetrically.

19. Method according to claim 18, wherein
the through-contacts (3) are sawn through.

20. Method according to claim 18 or 19, wherein
the three radiation-generating semiconductor chips (13) are arranged in the recess (6) before the cut-through.

21. Method according to one of the claims 18 to 20, wherein the housing body (1) is arranged on a printed circuit board (27) in such a way that the through-contacts (3) are contacted by conductor tracks of the printed circuit board (17).

## Revendications

1. Corps de boîtier (1) comprenant une face supérieure (2), une face inférieure (22) située à l'opposé de la face supérieure (2) et une surface latérale qui relie la face supérieure (2) et la face inférieure (22) et qui est prévue pour servir de surface de montage (19) pour le montage sur un circuit imprimé,
le corps de boîtier (1) présentant une pluralité de couches (8) qui contiennent un matériau en céramique, et une direction principale d'allongement des couches (23, 24, 25) s'étirant à la transversale de la surface de montage (19), le corps de boîtier (1) présentant des zones électroconductrices de raccordement de puce pour des puces semi-conductrices,
- chaque première zone électroconductrice de raccordement de puce étant un champ de raccordement de fil (30) conçu pour établir la connexion à un conducteur électrique,
- chaque deuxième zone électroconductrice de raccordement de puce étant un champ de puce (7) conçu pour le montage d'une puce semi-conductrice,
- les champs de raccordement de fil (30) étant agencés sur une première couche (24) et les champs de puce (7) sur une deuxième couche (25),
- le corps de boîtier présentant des connexions traversantes (3) électroconductrices, et
- les connexions traversantes (3) étant chacune de forme semi-tubulaire ou de forme semi-cylindrique,
**caractérisé en ce que**
- le corps de boîtier (1) est conçu pour exactement trois desdites puces semi-conductrices,
- le corps de boîtier (1) présentant pour chaque puce semi-conductrice deux des connexions traversantes (3) électroconductrices et adjacentes qui vont chacune de la face supérieure (2) à la face inférieure (22), et
- les connexions traversantes (3) passant chacune le long de la surface de montage (19).

2. Corps de boîtier (1) selon la revendication 1,
le matériau en céramique étant résistant aux UV.

3. Corps de boîtier (1) selon l'une quelconque des revendications 1 ou 2,
le matériau en céramique étant de l'Al₂O₃.

4. Corps de boîtier (1) selon l'une quelconque des revendications 1 ou 2,
le matériau en céramique étant de l'AlN.

5. Corps de boîtier (1) selon l'une quelconque des revendications précédentes,
les connexions traversantes (3) étant, sur la face supérieure (2) et/ou la face inférieure (22), entourées d'un revêtement métallique (4).

6. Corps de boîtier (1) selon la revendication 5, le revêtement métallique (4) étant réalisé en forme d'arc.

7. Corps de boîtier (1) selon l'une quelconque des revendications précédentes, qui présente une entaille (6) sur la face supérieure (2).

8. Corps de boîtier (1) selon la revendication 7,
l'entaille (6) étant agencée de telle sorte qu'elle se rapproche plus de la face latérale (29) située du côté opposé à la surface de montage (19) que de la surface de montage (19).

9. Corps de boîtier (1) selon l'une quelconque des revendications 7 ou 8,
l'entaille (6) étant réalisée en tant que réflecteur.

10. Corps de boîtier (1) selon l'une quelconque des revendications précédentes,
le rapport entre une hauteur (21) et une épaisseur (20) du corps de boîtier (1) étant de 1:1 à 2:1.

11. Composant (31) émettant par le côté, comprenant un corps de boîtier (1) selon l'une quelconque des revendications 7 à 10,
trois puces semi-conductrices (13) étant agencées dans l'entaille (6).

12. Composant (31) émettant par le côté, comprenant un corps de boîtier (1) selon l'une quelconque des revendications 7 à 10,
trois puces semi-conductrices (13) qui émettent un rayonnement à longueur d'onde différente étant agencées dans l'entaille (6).

13. Composant (31) émettant par le côté selon l'une quelconque des revendications 11 ou 12,
les puces semi-conductrices étant enveloppées d'un matériau d'enveloppe.

14. Composant (31) émettant par le côté selon l'une quelconque des revendications 11 à 13,
un élément optique étant agencé après les puces semi-conductrices.

15. Composant (31) émettant par le côté selon l'une quelconque des revendications 11 à 14,
ledit composant étant fixé sur un circuit imprimé (17).

16. Composant (31) émettant par le côté selon la revendication 15,
ledit composant étant connecté au circuit imprimé (17) de manière électroconductrice et/ou thermoconductrice.

17. Procédé de fabrication d'un corps de boîtier (1) selon l'une quelconque des revendications 1 à 10,
le corps de boîtier (1) étant construit en ce qu'une platine (27) est individualisée pour obtenir une pluralité de corps de boîtier (1).

18. Procédé selon la revendication 17, dans lequel
la platine (27) présente un empilement de couches en céramique (8) et sur une face supérieure qui correspond à la face supérieure (2) du corps de boîtier (1), une pluralité d'entailles (6) agencées de manière régulière,
les connexions traversantes (3), qui vont de la face supérieure (2) à la face inférieure (22), sont agencées entre deux entailles (6) adjacentes, et
la platine (27) est individualisée pour obtenir la pluralité de corps de boîtier de telle sorte que les connexions traversantes (3) sont sectionnées de manière asymétrique.

19. Procédé selon la revendication 18,
les connexions traversantes (3) étant scindées à la scie.

20. Procédé selon la revendication 18 ou 19,
les trois puces semi-conductrices (13) qui génèrent du rayonnement étant agencées dans l'entaille (6) avant la scission.

21. Procédé selon l'une quelconque des revendications 18 à 20, le corps de boîtier (1) étant agencé sur un circuit imprimé (27) de telle sorte que des pistes conductrices de la platine (17) entrent en contact avec les connexions traversantes (3).
